# EUROPÄISCHE PATENTANMELDUNG

(11) **EP 4 095 748 A1**
(43) Veröffentlichungstag der Anmeldung: **30.11.2022**
(21) Anmeldenummer: 21176593.8
(22) Anmeldetag: 28.05.2021
(51) Int. Cl.: G06K 9/62, G01R 31/392

(54) **HERSTELLEN EINER QUALITÄTSPRÜFANLAGE**

(71) Anmelder: Siemens Aktiengesellschaft, 80333 München (DE)
(72) Erfinder: Otte, Clemens, 81739 München (DE); Weber, Marc Christian, 80339 München (DE); Witt, Jonas, 96050 Bamberg (DE); Arzberger, Arno, 96135 Stegaurach (DE); Baldauf, Manfred, 91056 Erlangen (DE); Runkler, Thomas, 81929 München (DE); Steinbacher, Frank, 90542 Eckental (DE)

(57) **Zusammenfassung**

Die Erfindung betrifft ein Verfahren zum Herstellen einer Qualitätsprüfanlage (1), wobei die Qualitätsprüfanlage (1) ausgebildet ist ein Qualitätsprüfmodell (2) auszuführen, wobei das Qualitätsprüfmodell (2) eine Filtermaske (2a) und ein Gütemodell (2c) aufweist,
wobei die Qualitätsprüfanlage (1) zum Ermitteln von mindestens einem Qualitätsmerkmal (3c) mindestens einer Batteriezelle (4) ausgebildet ist und mindestens eine elektrochemische Impedanzspektroskopieeinheit zum Erfassen von spektroskopischen Prüfdaten (3) der mindestens einen Batteriezelle (4) innerhalb eines Frequenzbereiches aufweist,
wobei ein erstes maschinelle Lernverfahren und ein zweites maschinelle Lernverfahren anhand der spektroskopischen Lerndaten (3) gekoppelt und darauf abgestimmt, dass das erste maschinelle Lernverfahren eine Filtermaske (2a) erstellt (S22), welche die Analysedaten (3a, 3b) so ermittelt (S24), dass das zweite maschinelle Lernverfahren ein Gütemodell (2c) erstellt (S25), welches bezüglich einer Maximierung einer Güte des mindestens einen Qualitätsmerkmals (3c) optimiert ist, durchgeführt werden.

## Beschreibung

### HINTERGRUND DER ERFINDUNG

### Gebiet der Erfindung

Die vorliegende Erfindung betrifft ein Verfahren zum Herstellen einer Qualitätsprüfanlage, wobei die Qualitätsprüfanlage ausgebildet ist ein Qualitätsprüfmodell auszuführen, wobei das Qualitätsprüfmodell eine Filtermaske und ein Gütemodell aufweist. Die Erfindung betrifft außerdem eine zugehörige Qualitätsprüfanlage.

### Beschreibung des Stands der Technik

Eine möglichst effiziente und skalierbare Produktion von leistungsfähigen Batteriezellen, insbesondere Lithium-Ionen-Batterien, gewinnt angesichts rasant wachsender Nachfrage eine immer stärkere Bedeutung. Zugleich weist der industrielle Herstellungsprozess weiterhin große Fehler- und Ausschussquoten auf sowie große Unsicherheiten bei der Abschätzung von tatsächlicher Kapazität oder Betriebslebensdauer einzelner Batteriezellen. Vorhersagen dieser und weiterer Qualitätsparameter, insbesondere aus dedizierten Selbstentladungs-Messungen sind jedoch zeitaufwändig, zum Teil ein Vielfaches der Produktionsdauer oder mit hohem Ressourcenbedarf an Energie und/oder Platz verbunden.

Eine präzisere und weitaus schnellere Methode zur Untersuchung der Batteriezellengüte liegt in der sogenannten elektrochemischen Impedanzspektroskopie (EIS). Diese misst die Reaktion in Form einer Signalstärke oder Impulsantwort einer Batteriezelle auf dedizierte Strom- oder Spannungsanregungen über einen weiten Frequenzbereich, typischerweise mHz bis einige kHz.

Ein bekanntes Problem stellt dabei die Auswertung der komplexen Frequenzgangmessung, welche bis zu mehrere Tausend Messpunkte mit jeweils Real-/Imaginärteil des frequenzabhängigen Impedanzwerts umfasst, dar. Insbesondere die Ableitung oder Modellierung der interessanten Qualitätsmerkmale der Zelle aus den hochdimensionalen Rohdaten ist weiterhin eine Herausforderung.

Bislang werden vor allem Methoden der statistischen Datenanalyse und Spektralanalyse angewandt, um Merkmale einer Batteriezelle aus den gewonnenen Impedanzspektren abzuleiten. Gängig ist der Ansatz, existierende analytische, d.h. auf physikalischen Gleichungen basierende, Modelle an die spektralen Daten zu fitten. Die Effekte, die durch solche Modelle beschrieben werden können, sind jedoch begrenzt und bilden in der Regel nicht alle beobachteten Charakteristika in den Messdaten ab. Sie sind außerdem nicht dazu geeignet, neue Zusammenhänge oder Abhängigkeiten zu identifizieren, sondern lassen nur erkennen, wie gut das bisherige Verständnis oder Modell an die Daten angepasst werden kann.

In jüngerer Zeit werden darüber hinaus auch rein datenbasierende Verfahren, insbesondere Regressionsverfahren oder Verfahren des "Supervised Machine Learning" in der Literatur erwähnt oder angewendet. Hier wird meist anhand von Labortests eine Reihe von Batteriezellen dem Impedanzspektroskopie-Verfahren unterzogen und anschließend physikalische Messungen zur Bestimmung der tatsächlichen Kapazität oder Stresstests zur Bestimmung der Restlebensdauer durchgeführt. Auf diese Weise entstehen Datensätze, durch die Impedanzspektren mit den später gemessenen Qualitätsmerkmalen in Beziehung gesetzt werden können. Dadurch können Regressionsmodelle trainiert werden, die es später ermöglichen, für eine unbekannte Batteriezelle eine Vorhersage über die zu erwartenden Merkmale zu treffen. Was dabei jedoch ungelöst bleibt, ist Erkenntnis darüber, welche Charakteristika der EIS-Messung die Qualität maßgeblich beeinflussen. Um die Güte von unbekannten Batteriezellen, insbesondere in der Fertigung, frühzeitig zu bestimmen, muss die EIS Messung über den gesamten Frequenzbereich durchgeführt werden, um die Eingangsdaten zu erzeugen, die vom Regressionsmodell als Eingabe zur Vorhersage der Güte benötigt werden. Der Nachteil dieses Vorgehens ist ein sehr hoher Zeitaufwand.

Die Aufgabe der Erfindung besteht darin, eine Lösung für eine verbesserte Analyse der Güte von Batteriezellen bereitzustellen.

### ZUSAMMENFASSUNG DER ERFINDUNG

Die Erfindung ergibt sich aus den Merkmalen der unabhängigen Ansprüche. Vorteilhafte Weiterbildungen und Ausgestaltungen sind Gegenstand der abhängigen Ansprüche. Ausgestaltungen, Anwendungsmöglichkeiten und Vorteile der Erfindung ergeben sich aus der nachfolgenden Beschreibung und den Zeichnungen.

Die Erfindung betrifft ein Verfahren zum Herstellen einer Qualitätsprüfanlage. Die Qualitätsprüfanlage ist ausgebildet ein Qualitätsprüfmodell auszuführen, wobei das Qualitätsprüfmodell eine Filtermaske und ein Gütemodell aufweist.

Die Qualitätsprüfanlage ist außerdem zum Ermitteln von mindestens einem Qualitätsmerkmal mindestens einer Batteriezelle ausgebildet und weist mindestens eine elektrochemische Impedanzspektroskopieeinheit (EIS-Einheit) zum Erfassen von spektroskopischen Prüfdaten der mindestens einen Batteriezelle innerhalb eines Frequenzbereiches auf.

Das Verfahren umfasst die Schritte:
- Erstellen des Qualitätsprüfmodells und
- Herstellen der Qualitätsprüfanlage durch Implementieren des Qualitätsprüfmodells auf eine Recheneinheit der Qualitätsprüfanlage.

Der Schritt des Erstellens des Qualitätsprüfmodells umfasst wiederum die Schritte:
- Erfassen von spektroskopischen Lerndaten der mindestens einen Batteriezelle durch die mindestens eine elektrochemische Impedanzspektroskopieeinheit,
- Erstellen der Filtermaske durch ein erstes maschinelles Lernverfahren, wobei die Filtermaske zum Ermitteln von Analysedaten aus den spektroskopischen Prüfdaten ausgebildet ist, wobei das Ermitteln der Analysedaten eine Auswahl von mindestens einem Teilbereich des Frequenzbereichs der spektroskopischen Prüfdaten durch Hinzuziehen der Filtermaske beinhaltet, wobei der mindestens eine Teilbereich höchstens 50%, insbesondere höchstens 30% des gesamten Frequenzbereichs der spektroskopischen Prüfdaten abdeckt und
- Erstellen des Gütemodells durch ein zweites maschinelles Lernverfahren, wobei das Gütemodell zum Berechnen des mindestens einen Qualitätsmerkmals der mindestens einen Batteriezelle anhand der Analysedaten ausgebildet ist.

Das erste maschinelle Lernverfahren und das zweite maschinelle Lernverfahren werden anhand der spektroskopischen Lerndaten gekoppelt und darauf abgestimmt durchgeführt, dass das erste maschinelle Lernverfahren eine Filtermaske erstellt, welche die Analysedaten so ermittelt, dass das zweite maschinelle Lernverfahren ein Gütemodell erstellt, welches bezüglich einer Maximierung einer Güte des mindestens einen Qualitätsmerkmals optimiert ist. Das Qualitätsmerkmal kann auch als Gütemerkmal oder Eignungsmerkmal bezeichnet werden.

Ein Aspekt der Erfindung besteht darin, das erste maschinelle Lernverfahren und das zweite maschinelle Lernverfahren so anzuordnen und aufeinander abzustimmen, dass eine Filtermaske erstellt wird, welche die Erstellung eines Gütemodels, welches bezüglich einer Maximierung der Güte des mindestens einen Qualitätsmerkmals optimiert ist, ermöglicht. Die Filtermaske ist dazu ausgebildet eine deutliche Einschränkung und/oder Reduktion des Frequenzbereichs zu bewirken. Eine Filterung durch die Filtermaske führt zu einer reduzierten Zahl von Frequenzfenstern. Der Teilbereich des Frequenzbereichs der spektroskopischen Prüfdaten durch Hinzuziehen der Filtermaske umfasst insbesondere 50% des gesamten Frequenzbereichs der spektroskopischen Prüfdaten. In einer weiteren Ausführungsform umfasst der Teilbereich des Frequenzbereichs der spektroskopischen Prüfdaten durch Hinzuziehen der Filtermaske umfasst insbesondere 30%, 25%, 20%, 15%, 10%, 5%, 3% oder 1%. Eine höhere Reduktion und damit ein kleiner Teilbereich hat den Vorteil einer weniger komplexen Analyse und damit ein Erreichen von aussagekräftigen Gütekriterien mit weniger Aufwand und Ressourceneinsatz.

Um dies zu erreichen werden das erste maschinelle Lernverfahren und das zweite maschinelle Lernverfahren aufeinander abgestimmt, gekoppelt, simultan, gleichzeitig und/oder aufeinander basierend abgestimmt. Anders ausgedrückt, kann auch gesagt werden, dass die Filtermaske so erstellt wird, dass das bestmögliche Gütemodell erstellt werden kann. Technisch wird dies unter anderem erreicht, indem das erste maschinelle Lernverfahren und das zweite maschinelle Lernverfahren mit Daten, die jeweils aus denselben ersten spektroskopischen Daten resultieren, durchgeführt werden.

Nochmals anders ausgedrückt, bedeutet dies, dass das Training der Filtermaske durch das erste maschinelle Lernverfahren so durchgeführt wird, dass das erste maschinelle Lernverfahren eine Filtermaske liefert, welche den mindestens einen Teilbereich des Frequenzbereichs so auswählt, dass das zweite maschinelle Lernverfahren das Gütemodell so trainieren kann, dass das Gütemodell anhand des mindestens einen Teilbereichs die Qualitätsmerkmale mit höchster Genauigkeit, das heißt einer Maximierung der Güte des Gütemodells, berechnet.

Die spektroskopischen Daten sind optional normiert und/oder bestehen jeweils aus N diskreten Frequenzdatenpunkten.

Die hier vorgeschlagene Erfindung verfolgt somit das Ziel, mit Hilfe von Verfahren des maschinellen Lernens eine Transformation des komplexen elektrochemischen Impedanzspektroskopie-Spektrums (EIS-Spektrums) durchzuführen, die es erlaubt, die für bestimmte Qualitätsmerkmale wesentlichen Informationen aus dem EIS-Spektrum zu identifizieren. Die so gewonnenen Qualitätsmerkmale können für eine Verfahrensbeschleunigung und -präzisierung durch die Qualitätsprüfanlage, insbesondere Qualitäts-, Instandhaltung-, Prüfverfahren, verwendet werden.

So können die Ergebnisse des vorgeschlagenen Verfahrens genutzt werden, um im Folgenden nur noch eine reduzierte Zahl von Frequenzbereichen pro Batterieelle zielgerichtet untersuchen zu müssen, was die Methode effizienter und skalierbarer für die Anwendung im Fertigungs- und Qualitätssicherungsprozess macht.

Die hier vorgeschlagene Vorgehensweise ist nicht allein auf EIS-Messungen beschränkt, sondern kann auch für vergleichbare Messmethoden, insbesondere Methoden zur Messung eines Frequenzspektrum, zur Zellcharakterisierung, aber auch für eine Materialprüfung, welche mittels Infrarotspektroskopie durchgeführt wird oder eine Spektroskopie bezüglich Inhaltsstoffen, angewendet werden.

In einer Weiterbildung der Erfindung umfasst das mindestens eine Qualitätsmerkmal mindestens:
- eine Ladungsspeicherkapazität,
- eine Betriebslebensdauer,
- eine Restlebensdauer und/oder
- eine Selbstentladungsrate.
Das Gütemodell ist zum Berechnen des mindestens einen Qualitätsmerkmals der mindestens einen Batteriezelle anhand der Analysedaten ausgebildet. Verschiedene Ausbildungen des mindestens einen Qualitätsmerkmals haben den Vorteil, dass verschiede Aussagen über die Qualität einer Batteriezelle getroffen werden können.

In einer weiteren Weiterbildung der Erfindung ist die Qualitätsprüfanlage außerdem ausgebildet, das mindestens eine Qualitätsmerkmal für:
- eine Steuerung,
- ein Prüfverfahren und/oder
- eine Instandhaltung
einer Fertigung der mindestens einen Batteriezelle heranzuziehen.

Ein Heranziehen des mindestens einen Qualitätsmerkmals für die Steuerung der Fertigung der mindestens einen Batteriezelle umfasst insbesondere eine Modifikation von Fertigungsparametern, eine Adaption von Maschinenparametern und/oder eine Anpassung des Fertigungsprozesses.

Ein Heranziehen des mindestens einen Qualitätsmerkmals für ein Prüfverfahren der Fertigung der mindestens einen Batteriezelle umfasst insbesondere, dass zusätzliche Prüfzyklen geschalten werden, Prüfergebnisse weiteren Analysen unterzogen werden und/oder zusätzliche Prüfparameter erfasst werden.

Ein Heranziehen des mindestens einen Qualitätsmerkmals für eine Instandhaltung der Fertigung der mindestens einen Batteriezelle umfasst insbesondere eine Modifikation von Fertigungsparametern, eine zeitliche Unterbrechung der Fertigung, Wartungsarbeiten, eine Adaption von Maschinenparametern und/oder eine Anpassung des zukünftigen Fertigungsprozesses.

In einer weiteren Weiterbildung der Erfindung beinhaltet das Ermitteln der Analysedaten außerdem eine Anwendung eines Auto-Encoders, insbesondere eines Variational-Auto-Encoder. Der Auto-Encoder kann auch als Merkmalsextraktor bezeichnet werden und insbesondere eine Merkmalsextraktion aus den spektroskopischen Prüf- und Lerndaten vornehmen. Der Auto-Encoder wird zusätzlich zu der Filtermaske auf die spektroskopischen Prüf- und/oder Lerndaten angewandt und so die Analysedaten erstellt.

In einer weiteren Weiterbildung der Erfindung weist das Erstellen des Qualitätsprüfmodells außerdem den Schritt auf:
- Erstellen des Auto-Encoders durch ein drittes maschinelles Lernverfahren.

In einer weiteren Weiterbildung der Erfindung werden das erste maschinelle Lernverfahren, das zweite maschinelle Lernverfahren und das dritte maschinelle Lernverfahren mit Daten, gekoppelt anhand der spektroskopischen Lerndaten und darauf abgestimmt durchgeführt, so dass das erste maschinelle Lernverfahren eine Filtermaske erstellt und das dritte maschinelle Lernverfahren einen Auto-Encoder erstellt, wobei die Filtermaske und der Auto-Encoder die Analysedaten so ermittelt, dass das zweite maschinelle Lernverfahren ein Gütemodell erstellt, welches bezüglich der Maximierung der Güte des mindestens einen Qualitätsmerkmals optimiert ist.

Wie bereits die Abstimmung der Erstellung der Filtermaske und des Gütemodells hat die zusätzliche Abstimmung der Erstellung des Auto-Encoders den Vorteil, dass so ein Gütemodell erstellt wird, welches anhand des mindestens einen Teilbereichs und der Analysedaten die Qualitätsmerkmale mit höchster Genauigkeit, das heißt einer Maximierung der Güte des Gütemodells, berechnet

In einer weiteren Weiterbildung der Erfindung sind die Analysedaten eine latente Darstellung der spektroskopischen Prüfdaten, insbesondere durch die Modifikation durch den Auto-Encoder. Die latente Darstellung kann auch als komprimierte Darstellung oder eine Darstellung, umfassend eine reduzierte Anzahl an Dimensionen, bezeichnet werden. Der Auto-Encoder hat somit den Vorteil die Komplexität der spektroskopischen Prüf- und/oder Lerndaten zu reduzieren.

In einer weiteren Weiterbildung der Erfindung weisen die Analysedaten eine reduzierte Komplexität gegenüber den spektroskopischen Prüfdaten auf. Dies hat den Vorteil, dass dem Gütemodell Daten einer reduzierten Komplexität bereitgestellt werden und insbesondere eine Merkmalsextraktion bereits stattgefunden hat.

Zusammengefasst wird ein (variationaler) Auto-Encoder auf Basis des maskierten Eingabespektrums daraufhin trainiert, eine in ihrer Komplexität reduzierte, latente Darstellung der maskierten Eingangsspektren zu generieren (= Ausgabe des Encoders). Der Auto-Encoder kann ein Clustering, eine Sortierung, eine Reproduktion, eine Extraktion von Merkmalen und/oder eine Filterung des maskierten Eingabespektrums vornehmen. Dies kann auch als Regularisierung bezeichnet werden.

In einer weiteren Weiterbildung der Erfindung ist das Gütemodell außerdem zum Berechnen von mindestens einem zweiten Qualitätsmerkmal der mindestens einen Batteriezelle anhand der Analysedaten ausgebildet. Dies hat den Vorteil, dass insbesondere basierend auf einer Größe der Unsicherheit des bestimmten Qualitätsmerkmals verschiedene weitere Verarbeitungsschritte eingeleitet werden können, insbesondere eine vollständige Nachmessung des EIS-Spektrums für die betrachtete Batteriezelle veranlasst werden oder eine direkte Aussortierung.

In einer weiteren Weiterbildung der Erfindung weist das Qualitätsprüfmodell mindestens ein zweites Gütemodell auf, welches zum Berechnen von mindestens einem zweiten Qualitätsmerkmal der mindestens einen Batteriezelle anhand der Analysedaten ausgebildet ist. In dieser Ausgestaltung könnten mehrere Gütemodelle trainiert werden, insbesondere mit zunehmender Anzahl von Frequenzen, insbesondere durch Abschwächung der L1-Regularisierung beim Training. In Ausführungsform würden die Gütemodelle insbesondere als Kette ausgeführt werden: ein nachfolgendes Gütemodell wird nur ausgewertet, wenn die prognostizierte Unsicherheit des vorangegangenen Gütemodells zu groß ist. Ein hierdurch erreichbarer Vorteil wäre eine Zeitersparnis durch Vermeiden von nicht zwingend benötigten Frequenzmessungen.

In einer weiteren Ausgestaltung ist es außerdem denkbar, dass für Batteriezellen verschiedenen Typs unterschiedliche Frequenzmasken und Gütemodelle trainiert werden.

In einer weiteren Weiterbildung der Erfindung beinhaltet das Ermitteln der Analysedaten außerdem eine Anwendung:
- eines Dimensionsreduktionsverfahren, insbesondere t-SNE,
- eines Transformationsverfahrens und/oder
- einer Merkmalsextraktion auf die spektroskopischen Prüfdaten.
Dies hat den Vorteil, dass verschiedene Verfahren zur Ausbildung des Auto-Encoders oder als Alternative zu dem Auto-Encoder eingesetzt werden können.

In einer weiteren Weiterbildung der Erfindung beinhaltet das Ermitteln der Analysedaten außerdem eine Anwendung:
- eines Gruppierens,
- eines Sortierens,
- einer Regularisierung,
- eines Reproduzierens und/oder
- eines Filterns der spektroskopischen Prüfdaten.
Dies hat den Vorteil, die Komplexität der spektroskopischen Prüf- und/oder Lerndaten zu reduzieren, gegebenenfalls eine Reduktion bei zuführen und so den Aufwand für das Gütemodell zu reduzieren.

In einer weiteren Weiterbildung der Erfindung weisen die spektroskopischen Lerndaten Testdaten und Trainingsdaten auf. Dies hat den Vorteil, dass die maschinellen Lernverfahren sowohl trainiert als auch getestet werden können.

In einer weiteren Weiterbildung der Erfindung wird das Gütemodell mittels:
- eines Convolutional Neural Network (CNN),
- eines Deep Neural Network,
- eines linearen Modells, insbesondere eines Partial Least Squares (PLS) Modells,
- eines Bayes'sches Neuronales Netz (BNN) oder
- eines Bayes'sches Netz (BN)
ausgeführt.

Bayes'sches Neuronales Netz (BNN) kann neben den Mittelwerten der Qualitätsmerkmale auch Aussagen über die zu erwartende Unsicherheit der Prognose erzeugen.

Die Erfindung umfasst außerdem eine Qualitätsprüfanlage hergestellt nach einem erfindungsgemäßen Verfahren.

Die Erfindung umfasst außerdem ein Verfahren zur Verwendung einer erfindungsgemäßen Qualitätsprüfanlage,
mit den Schritten:
- Ermitteln von Analysedaten aus den spektroskopischen Prüfdaten durch die Filtermaske, wobei das Ermitteln der Analysedaten eine Auswahl von mindestens einem Teilbereich des Frequenzbereichs der spektroskopischen Prüfdaten durch Hinzuziehen der Filtermaske beinhaltet, wobei der mindestens eine Teilbereich höchstens 50%, insbesondere höchstens 30% des gesamten Frequenzbereichs der spektroskopischen Prüfdaten abdeckt und
- Berechnen des mindestens einen Qualitätsmerkmals der mindestens einen Batteriezelle anhand der Analysedaten durch das Gütemodell.

Die Erfindung bietet den Vorteil, dass nach bisherigem Stand der Technik EIS-Messungen über den ganzen Frequenzbereich ausgeführt werden, was einen hohen Zeitaufwand mit sich bringt, insbesondere wenn die niedrigen Frequenzen mit vermessen werden. Das heißt, das vorgeschlagene Verfahren ermöglicht eine Zeiteinsparung, wenn nur noch die für die Qualität der Zellen charakteristischen Frequenzen vermessen werden müssen. Langwierige Messungen wären bei der großen Zahl von zu charakterisierenden Zellen nicht praktikabel.

Weiterhin ermöglicht das erfindungsgemäße Verfahren nicht nur die End-Of-Line Qualität der Zellen zu beurteilen, sondern auch Aussagen zu der zu erwartenden Lebensdauer im Betrieb der Batterie zu ermitteln. Hierfür ist es Voraussetzung, dass in Laborstresstests an einer geringen Anzahl von Zellen während Alterungsversuchen in gewissen Zeitabständen Impedanzspektren aufgezeichnet werden.

Zudem kann die EIS-Messung die lange dauernde Bestimmung der Selbstentladung der Zellen während der Fertigung ersetzen. Hierzu wird für eine Trainingsperiode zusätzlich zur Selbstentladungsbestimmung auch das komplette EIS-Spektrum aufgezeichnet, so dass es zum Training der oben beschriebenen Methoden genutzt werden kann.

In der späteren Produktion kann dann auf die Selbstentladungsmessung verzichtet und stattdessen nur die, bis dahin zeitlich optimierte, EIS-Messung durchgeführt werden. Hierdurch ergibt sich eine deutliche Zeitersparnis während der Zellherstellung.

### KURZE BESCHREIBUNG DER ZEICHNUNGEN

Die Besonderheiten und Vorteile der Erfindung werden aus den nachfolgenden Erläuterungen mehrerer Ausführungsbeispiele anhand der schematischen Zeichnungen ersichtlich.

Es zeigen
- Fig. 1: ein Ablaufdiagramm des erfindungsgemäßen Verfahrens,
- Fig. 2: eine schematische Darstellung und einen Ablauf des Erstellens des Qualitätsprüfmodells und
- Fig. 3: eine schematische Darstellung und einen Ablauf einer Anwendung der Qualitätsprüfanlage.

### DETAILLIERTE BESCHREIBUNG DER ERFINDUNG

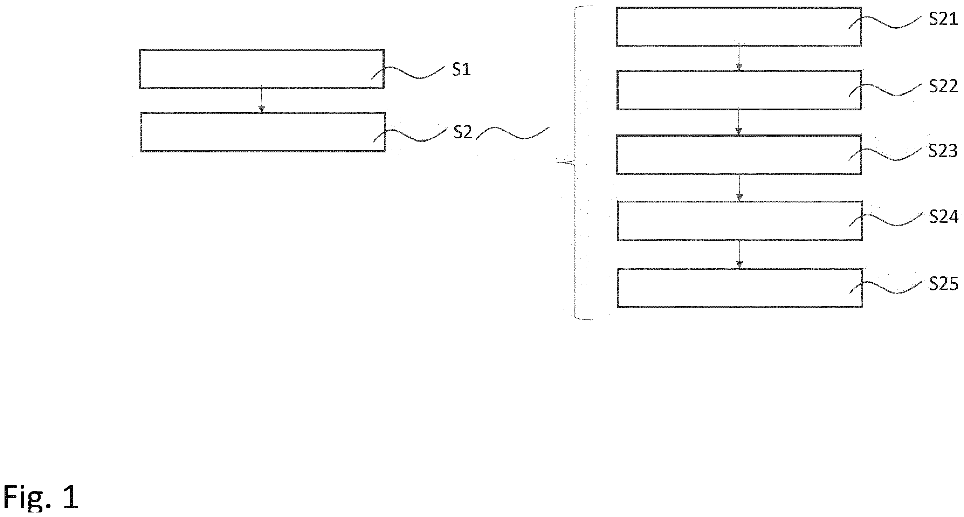

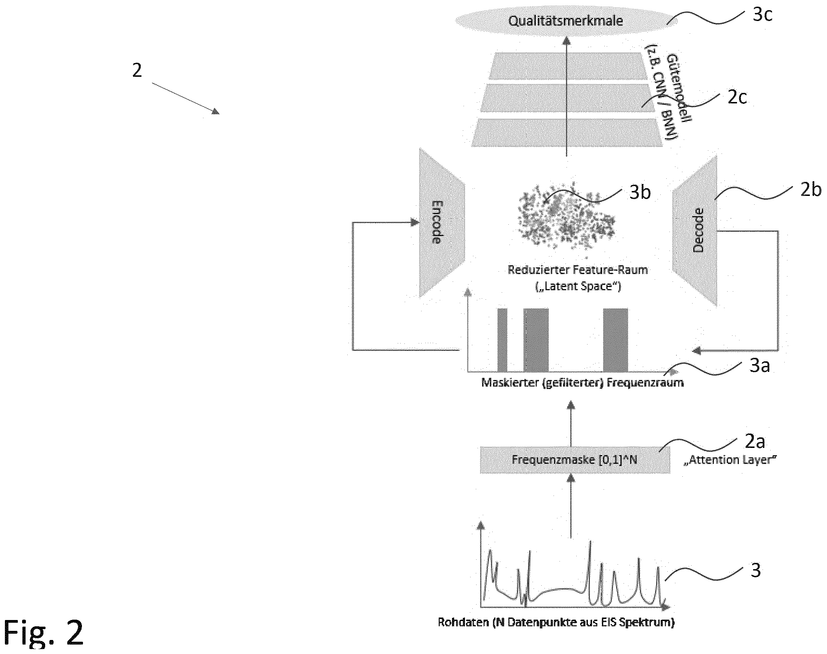

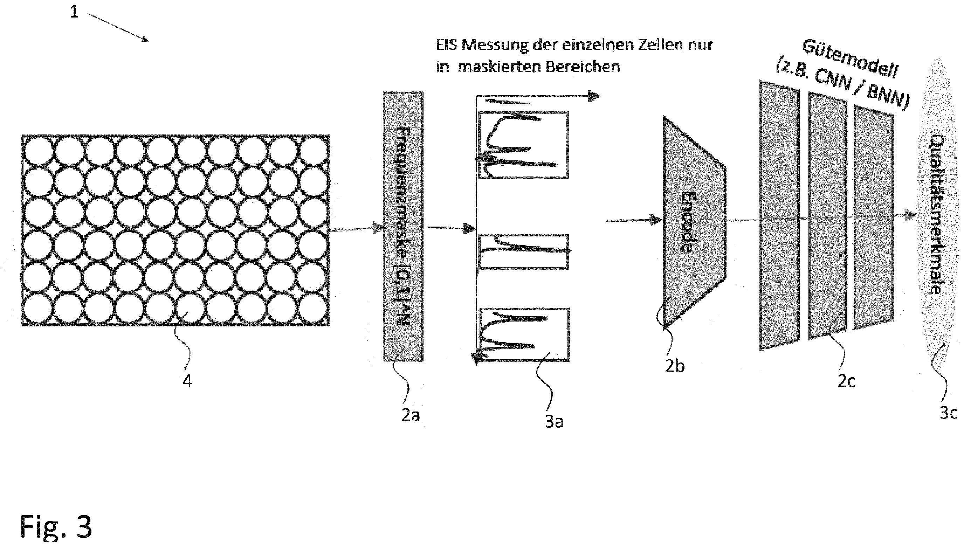

Fig. 1 zeigt ein Ablaufdiagramm des erfindungsgemäßen Verfahrens zum Herstellen einer Qualitätsprüfanlage 1 (dargestellt in Fig. 2 bzw. 3), wobei die Qualitätsprüfanlage 1 ausgebildet ist ein Qualitätsprüfmodell 2 (dargestellt in Fig. 2 bzw. 3) auszuführen, wobei das Qualitätsprüfmodell 2 eine Filtermaske 2a (dargestellt in Fig. 2 bzw. 3) und ein Gütemodell 2c (dargestellt in Fig. 2 bzw. 3) aufweist, wobei die Qualitätsprüfanlage 1 zum Ermitteln von mindestens einem Qualitätsmerkmal 3c (dargestellt in Fig. 2 bzw. 3) mindestens einer Batteriezelle 4 (dargestellt in Fig. 2 bzw. 3) ausgebildet ist und mindestens eine elektrochemische Impedanzspektroskopieeinheit zum Erfassen von spektroskopischen Prüfdaten 3 (dargestellt in Fig. 2 bzw. 3) der mindestens einen Batteriezelle 4 innerhalb eines Frequenzbereiches aufweist.

Das Verfahren umfasst die Schritte:
- Schritt S1: Erstellen des Qualitätsprüfmodells 2 und
- Schritt S2: Herstellen der Qualitätsprüfanlage 1 durch Implementieren des Qualitätsprüfmodells 2 auf eine Recheneinheit der Qualitätsprüfanlage 1,
   wobei das Erstellen des Qualitätsprüfmodells 2 die Schritte aufweist:
   - Schritt S21: Erfassen von spektroskopischen Lerndaten 3 (dargestellt in Fig. 2 bzw. 3) der mindestens einen Batteriezelle 4 durch die mindestens eine elektrochemische Impedanzspektroskopieeinheit,
   - Schritt S22: Erstellen der Filtermaske 2a durch ein erstes maschinelles Lernverfahren, wobei die Filtermaske 2a zum Ermitteln (siehe Schritt S24) von Analysedaten 3a (dargestellt in Fig. 2 bzw. 3), 3b (dargestellt in Fig. 2 bzw. 3) aus den spektroskopischen Prüfdaten 3 ausgebildet ist,
   - Schritt S24: wobei das Ermitteln der Analysedaten 3a, 3b eine Auswahl (Schritt S24a, nicht dargestellt) von mindestens einem Teilbereich des Frequenzbereichs der spektroskopischen Prüfdaten 3 durch Hinzuziehen der Filtermaske 2a beinhaltet, wobei der mindestens eine Teilbereich höchstens 50%, insbesondere höchstens 30% des gesamten Frequenzbereichs der spektroskopischen Prüfdaten 2a abdeckt,
   - Schritt S25: Erstellen des Gütemodells 2c durch ein zweites maschinelles Lernverfahren, wobei das Gütemodell 2c zum Berechnen des mindestens einen Qualitätsmerkmals 3c der mindestens einen Batteriezelle 4 anhand der Analysedaten 3a, 3b ausgebildet ist,
wobei das erste maschinelle Lernverfahren und das zweite maschinelle Lernverfahren anhand der spektroskopischen Lerndaten 3 gekoppelt und darauf abgestimmt, dass das erste maschinelle Lernverfahren eine Filtermaske 2a erstellt (siehe Schritt S22), welche die Analysedaten 3a, 3b so ermittelt (siehe Schritt S24), dass das zweite maschinelle Lernverfahren ein Gütemodell 2c erstellt (siehe Schritt S25), welches bezüglich einer Maximierung einer Güte des mindestens einen Qualitätsmerkmals 3c optimiert ist, durchgeführt werden.

Optional beinhaltet das Ermitteln (siehe Schritt S24) der Analysedaten 3a, 3b außerdem eine Anwendung (S24b, nicht dargestellt) eines Auto-Encoders 2b, insbesondere eines Variational-Auto-Encoder 2b (dargestellt in Fig. 2 bzw. 3).

Das Erstellen (siehe Schritt S1) des Qualitätsprüfmodells 2 weist somit optimal außerdem den Schritt auf:
- Schritt S23: Erstellen des Auto-Encoders 2b durch ein drittes maschinelles Lernverfahren.

Das erste maschinelle Lernverfahren, das zweite maschinelle Lernverfahren und das dritte maschinelle Lernverfahren werden somit mit Daten, gekoppelt anhand der spektroskopischen Lerndaten 3 und darauf abgestimmt durchgeführt, dass das erste maschinelle Lernverfahren eine Filtermaske 2a erstellt (siehe Schritt S22) und das dritte maschinelle Lernverfahren einen Auto-Encoder 2b erstellt (siehe Schritt S23), wobei die Filtermaske 2a und der Auto-Encoder 2b die Analysedaten 3a, 3b so ermittelt (siehe Schritt S24), dass das zweite maschinelle Lernverfahren ein Gütemodell 2c erstellt (siehe Schritt S25), welches bezüglich der Maximierung der Güte des mindestens einen Qualitätsmerkmals 3c optimiert ist.

Fig. 2 zeigt eine schematische Darstellung und einen Ablauf des Erstellens (siehe Schritt S1, Fig. 1) des Qualitätsprüfmodells 2.

Eingabewerte 3 sind unverarbeiteten (gegebenenfalls normierten) EIS-Spektren 3 (bestehend jeweils aus N diskreten Frequenzdatenpunkten) aus einem Trainingsdatensatz von verschiedenen Batteriezellen 4.

Die hier beschriebene Idee sieht vor, durch ein kombiniertes Verfahren von "Supervised Learning"- und "Unsupervised Learning"-Methoden, z.B. unter Verwendung von "Variational-Auto-Encoder" (VAE) 2b oder Dimensionsreduktionsverfahren 2b (wie bspw. t-SNE 2b), die in den EIS-Rohdaten 3 enthaltenen Informationen hinsichtlich der Zielmerkmale 3c (Lebensdauer, Kapazität,...) so zu transformieren, dass sich daraus eine Einschränkung 2a auf die relevanten Frequenzbereiche 3a (oder Kombinationen von Bereichen) ableiten lässt, die in Zukunft notwendig ist, um unbekannte Batteriezellen 4 auf ihre Güte oder Eignung hin optimal zu bewerten.

Die Messung von demnach unmaßgeblichen Frequenzbereichen kann also entfallen, um Zeit und Ressourcen bei der (Massen-)Fertigung einzusparen.

Ein trainierbarer Vektor-Layer 2a, auch als "Attention Layer" 2a oder Frequenzmaske 2a bezeichenbar, von ebenfalls N Gewichten im Wertebereich [0, 1] transformiert das Eingabespektrum 3 dann zunächst in eine reduzierte Zahl von Frequenzen 3a (maskiertes Eingabespektrum 3a). Das Training dieser Gewichte 2a ist gekoppelt an die darauffolgende Optimierung des Gütemodells 2c sowie des Auto-Encoders 2b. Das heißt, dass das Training des Attention Layers 2a darauf optimiert und abgestimmt wird, die Bereiche herauszufiltern, mit denen das Gütemodell 2c die besten Ergebnisse liefert. Das Training des Attention Layers 2a und des Gütemodells 2c findet somit simultan statt. Es werden also diejenigen Frequenzbereiche bevorzugt ausgewählt, die für die Anpassung der nachfolgenden Lernziele 3c (des Gütemodells 2c und des Auto-Encoders 2b) besonders relevant sind.

Ein (variationaler) Auto-Encoder 2b wird auf Basis des maskierten Eingabespektrums 3a daraufhin trainiert, eine in ihrer Komplexität reduzierte, latente Darstellung der maskierten Eingangsspektren 3a zu generieren (= Ausgabe 3b des Encoders 2b). Der Auto-Encoder 2b kann ein Clustering, eine Sortierung, eine Reproduktion, eine Extraktion von Merkmalen und/oder eine Filterung des maskierten Eingabespektrums 2a vornehmen. Dies kann auch als Regularisierung 2b bezeichnet werden.

Die Ausgabe 3b des Auto-Encoders 2b , also die latente Repräsentation 3b des Rohdatenspektrums 3, wird gleichzeitig als Eingabe zum Training eines überwachten ("supervised"), tiefen "Gütemodells" 2c (z.B. bestehend aus einem "convolutional neural network" (CNN) 2c oder einem unsicherheitsbehafteten Bayesschen Netzwerks (BNN) 2c) verwendet, bei dem eine Vorhersage der Qualitätsmerkmale 3c der Zellen 4 gelernt wird (Zielgrößen 3c für diesen Lernschritt stammen aus Messungen, die im Anschluss an die EIS-Spektren 3 an den Batteriezellen 4 durchgeführt werden).

Die reduzierte Darstellung 3b der Rohspektren 3 im maskierten Frequenzraum 3a (Ausgabe des Attention Layers 2a) enthält im Falle eines erfolgreich abgeschlossenen Trainings nur diejenigen Frequenzbereiche, die zur Vorhersage (durch das Gütemodell 2c) bzw. Reproduktion (durch den Auto-Encoder 2b) der Qualitätskriterien 3c notwendig und relevant sind.

Außerdem findet eine implizite Korrektur oder Unterdrückung von Sensorrauschen in der Impedanzspektroskopie-Messung 3 statt. Dies kann insbesondere durch geeignete Kodierung in der latenten Repräsentation 3b durchgeführt werden, d.h. es wird gelernt, verrauschte Sensorwerte 3 auf die gleiche latente Repräsentation 3b abzubilden, wie die nichtverrauschten Werte 3b und letztere damit aus den verrauschten Messungen 3 zu rekonstruieren.

Fig. 3 zeigt eine schematische Darstellung und einen Ablauf einer Anwendung der Qualitätsprüfanlage 1.

Bei der Herstellung von Batteriezellen 4 lassen sich die trainierten Gütemodelle 2c folgendermaßen zur Effizienzsteigerung einsetzen:
- Die Batteriezellen 4 einer Charge werden nur in den ausgewählten Frequenzbereichen einem EIS-Scan unterzogen; die dazu benötigte Frequenzmaske 2a wird dem einmaligen Training des Modells (siehe Beschreibung Fig. 2) entnommen.
- Die Ergebnisse der eingeschränkten EIS-Spektren der Zellen 4 werden als Eingabe für das auf diesen Frequenzbereichen vortrainierte (CNN/Deep) Gütemodell 2c verwendet, um die zu erwartete Güte 3c jeweils vorherzusagen.
- Basierend auf den Vorhersagen des Gütemodells 2c können einzelne Zellen 4 aussortiert werden oder bei entsprechender Unklarheit der Gütemodelle 2c einer vollständigen Nachprüfung unterzogen werden.

Obwohl die Erfindung im Detail durch die Ausführungsbeispiele näher illustriert und beschrieben wurde, ist die Erfindung durch die offenbarten Beispiele nicht eingeschränkt und andere Variationen können vom Fachmann daraus abgeleitet werden, ohne den Schutzumfang der Erfindung zu verlassen.

## Patentansprüche

1. Verfahren zum Herstellen einer Qualitätsprüfanlage (1), wobei die Qualitätsprüfanlage (1) ausgebildet ist ein Qualitätsprüfmodell (2) auszuführen, wobei das Qualitätsprüfmodell (2) eine Filtermaske (2a) und ein Gütemodell (2c) aufweist, wobei die Qualitätsprüfanlage (1) zum Ermitteln von mindestens einem Qualitätsmerkmal (3c) mindestens einer Batteriezelle (4) ausgebildet ist und mindestens eine elektrochemische Impedanzspektroskopieeinheit zum Erfassen von spektroskopischen Prüfdaten (3) der mindestens einen Batteriezelle (4) innerhalb eines Frequenzbereiches aufweist,
mit den Schritten:
- Erstellen (S1) des Qualitätsprüfmodells (2) und
- Herstellen (S2) der Qualitätsprüfanlage (1) durch Implementieren des Qualitätsprüfmodells (2) auf eine Recheneinheit der Qualitätsprüfanlage (1),
wobei das Erstellen des Qualitätsprüfmodells (2) die Schritte aufweist:
- Erfassen (S21) von spektroskopischen Lerndaten (3) der mindestens einen Batteriezelle (4) durch die mindestens eine elektrochemische Impedanzspektroskopieeinheit,
- Erstellen (S22) der Filtermaske (2a) durch ein erstes maschinelles Lernverfahren, wobei die Filtermaske (2a) zum Ermitteln von Analysedaten (3a, 3b) aus den spektroskopischen Prüfdaten (3) ausgebildet ist, wobei das Ermitteln (S24) der Analysedaten (3a, 3b) eine Auswahl (S24a) von mindestens einem Teilbereich des Frequenzbereichs der spektroskopischen Prüfdaten (3) durch Hinzuziehen der Filtermaske (2a) beinhaltet, wobei der mindestens eine Teilbereich höchstens 50%, insbesondere höchstens 30% des gesamten Frequenzbereichs der spektroskopischen Prüfdaten (2a) abdeckt,
- Erstellen (S25) des Gütemodells (2c) durch ein zweites maschinelles Lernverfahren, wobei das Gütemodell (2c) zum Berechnen des mindestens einen Qualitätsmerkmals (3c) der mindestens einen Batteriezelle (4) anhand der Analysedaten (3a, 3b) ausgebildet ist,
wobei das erste maschinelle Lernverfahren und das zweite maschinelle Lernverfahren anhand der spektroskopischen Lerndaten (3) gekoppelt und darauf abgestimmt, dass das erste maschinelle Lernverfahren eine Filtermaske (2a) erstellt (S22), welche die Analysedaten (3a, 3b) so ermittelt (S24), dass das zweite maschinelle Lernverfahren ein Gütemodell (2c) erstellt (S25), welches bezüglich einer Maximierung einer Güte des mindestens einen Qualitätsmerkmals (3c) optimiert ist, durchgeführt werden.

2. Verfahren nach Anspruch 1,
wobei das mindestens eine Qualitätsmerkmal (3c) mindestens:
- eine Ladungsspeicherkapazität,
- eine Betriebslebensdauer,
- eine Restlebensdauer und/oder
- eine Selbstentladungsrate
umfasst.

3. Verfahren nach einem der vorhergehenden Ansprüche,
wobei die Qualitätsprüfanlage (1) außerdem ausgebildet ist, das mindestens eine Qualitätsmerkmal (3) für:
- eine Steuerung,
- ein Prüfverfahren und/oder
- eine Instandhaltung
einer Fertigung der mindestens einen Batteriezelle (4) heranzuziehen.

4. Verfahren nach einem der vorhergehenden Ansprüche,
wobei das Ermitteln (S24) der Analysedaten (3a, 3b) außerdem eine Anwendung (S24b) eines Auto-Encoders (2b), insbesondere eines Variational-Auto-Encoder (2b), beinhaltet.

5. Verfahren nach Anspruch 4,
wobei das Erstellen (S1) des Qualitätsprüfmodells (2) außerdem den Schritt aufweist:
- Erstellen (S23) des Auto-Encoders (2b) durch ein drittes maschinelles Lernverfahren.

6. Verfahren nach Anspruch 5,
wobei das erste maschinelle Lernverfahren, das zweite maschinelle Lernverfahren und das dritte maschinelle Lernverfahren mit Daten, gekoppelt anhand der spektroskopischen Lerndaten (3) und darauf abgestimmt, dass das erste maschinelle Lernverfahren eine Filtermaske (2a) erstellt (S22) und das dritte maschinelle Lernverfahren einen Auto-Encoder (2b) erstellt (S23), wobei die Filtermaske (2a) und der Auto-Encoder (2b) die Analysedaten (3a, 3b) so ermittelt (S24), dass das zweite maschinelle Lernverfahren ein Gütemodell (2c) erstellt (S25), welches bezüglich der Maximierung der Güte des mindestens einen Qualitätsmerkmals (3c) optimiert ist, durchgeführt werden.

7. Verfahren nach einem der vorhergehenden Ansprüche,
wobei die Analysedaten (3a, 3b) eine latente Darstellung der spektroskopischen Prüfdaten (3) sind.

8. Verfahren nach einem der vorhergehenden Ansprüche,
wobei die Analysedaten (3a, 3b) eine reduzierte Komplexität gegenüber den spektroskopischen Prüfdaten (3) aufweisen.

9. Verfahren nach einem der vorhergehenden Ansprüche,
wobei das Gütemodell (2c) außerdem zum Berechnen von mindestens einem zweiten Qualitätsmerkmal der mindestens einen Batteriezelle (4) anhand der Analysedaten (3a, 3b) ausgebildet ist oder
wobei das Qualitätsprüfmodell (2) mindestens ein zweites Gütemodell aufweist, welches zum Berechnen von mindestens einem zweiten Qualitätsmerkmal der mindestens einen Batteriezelle (4) anhand der Analysedaten (3a, 3b) ausgebildet ist.

10. Verfahren nach einem der vorhergehenden Ansprüche,
wobei das Ermitteln (S24) der Analysedaten (3a, 3b) außerdem eine Anwendung:
- eines Dimensionsreduktionsverfahren, insbesondere t-SNE,
- eines Transformationsverfahrens und/oder
- einer Merkmalsextraktion auf die spektroskopischen Prüfdaten (3)
beinhaltet.

11. Verfahren nach einem der vorhergehenden Ansprüche,
wobei das Ermitteln der Analysedaten (S24) außerdem eine Anwendung:
- eines Gruppierens,
- eines Sortierens,
- einer Regularisierung,
- eines Reproduzierens und/oder
- eines Filterns der spektroskopischen Prüfdaten (3)
beinhaltet.

12. Verfahren nach einem der vorhergehenden Ansprüche,
wobei die spektroskopischen Lerndaten (3) Testdaten und Trainingsdaten aufweisen.

13. Verfahren nach einem der vorhergehenden Ansprüche,
wobei das Gütemodell (2c) mittels:
- eines Convolutional Neural Network (CNN),
- eines Deep Neural Network,
- eines linearen Modells, insbesondere eines Partial Least Squares (PLS) Modells,
- eines Bayes'sches Neuronales Netz (BNN) oder
- eines Bayes'sches Netz (BN)
ausgeführt wird.

14. Qualitätsprüfanlage (1) hergestellt nach einem Verfahren nach einem der vorherigen Ansprüche.

15. Verfahren zur Verwendung einer Qualitätsprüfanlage (1) nach Anspruch 14,
mit den Schritten:
- Ermitteln von Analysedaten (3a, 3b) aus den spektroskopischen Prüfdaten (3) durch die Filtermaske (2a), wobei das Ermitteln der Analysedaten (3a, 3b) eine Auswahl von mindestens einem Teilbereich des Frequenzbereichs der spektroskopischen Prüfdaten (3) durch Hinzuziehen der Filtermaske (2a) beinhaltet, wobei der mindestens eine Teilbereich höchstens 50%, insbesondere höchstens 30% des gesamten Frequenzbereichs der spektroskopischen Prüfdaten (3) abdeckt und
- Berechnen des mindestens einen Qualitätsmerkmals (3c) der mindestens einen Batteriezelle (4) anhand der Analysedaten (3a, 3b) durch das Gütemodell (2c).
